# EUROPEAN PATENT APPLICATION

(11) **EP 3 992 716 A1**
(43) Date of publication of application: **04.05.2022**
(21) Application number: 20831467.4
(22) Date of filing: 26.06.2020
(51) Int. Cl.: G03F 9/00, G02B 7/182

(54) **MIRROR-MOUNTING MEMBER, POSITION-MEASURING MIRROR USING SAME, AND EXPOSURE DEVICE**

(30) Priority: 28.06.2019 JP 2019122425
(71) Applicant: Kyocera Corporation, Kyoto-shi, Kyoto 612-8501 (JP)
(72) Inventor: INOUE, Tetsuya, Kyoto-shi, Kyoto 612-8501 (JP)
(74) Representative: Viering, Jentschura & Partner mbB Patent- und Rechtsanwälte
(86) International application number: PCT/JP2020/025391
(87) International publication number: WO 2020/262674

(57) **Abstract**

A mirror mounting member is formed of a ceramic structure with a prismatic or angular cylindrical shape and includes, as outer surfaces, a joining surface configured to join to a to-be-joined surface, and an inclined surface inclined relative to the to-be-joined surface. The inclined surface is a mounting surface on which is mounted a reflective film that reflects light emitted from a light source. The joining surface includes a plurality of first grooves extending in a longitudinal direction of the structure and a plurality of second grooves intersecting the first grooves. The first grooves are open at both ends, and the second grooves are sealed at an end portion located on a side where light is reflected by the reflective film.

## Description

### Technical Field

The present disclosure relates to, for example, a mirror mounting member for mounting a reflective film used for measuring a position of a substrate stage in an exposure apparatus, a position measuring mirror using the same, and an exposure apparatus.

### Background Art

A known method of measuring a position of a stage on which a substrate is mounted, using a laser interferometer and a reflecting mirror has been used in an electron beam exposure apparatus such as a liquid immersion exposure apparatus (Patent Document 1).

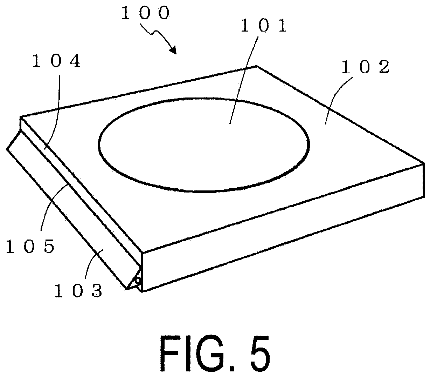

Such an exposure apparatus includes, as illustrated in FIG. 5, a substrate stage 100 including a substrate chuck (not illustrated) that holds a substrate 101, and a surrounding member 102 surrounding the substrate 101. The substrate stage 100, the driving of which is controlled by a control unit, is movable in a region including an exposure region in which the substrate 101 is exposed via a projection optical system and a measurement region in which the substrate 101 is measured.

For the purpose of accurately measuring the position of the substrate stage 100, Patent Document 1 proposes a liquid immersion exposure apparatus in which an inclined surface mirror 103 is attached to a mirror 104 mounted on a side surface of the substrate stage 100. Specifically, an optical axis of light emitted from an interferometer (not illustrated) is guided by the inclined surface mirror 103 to an upper portion of the substrate stage 100 to be reflected by a reference mirror (not illustrated) fixed above the substrate stage 100. The optical axis reflected from the reference mirror is reflected by the inclined surface mirror 103 and returns to the interferometer, and the light interferes with the reference light. As a result, the amount of change in the substrate stage 100 in a predetermined direction is measured, and its position relative to the reference position is calculated.

### Citation List

### Patent Literature

Patent Document 1: JP 2008-124219 A

### Summary

A mirror mounting member according to the present disclosure is formed of a structure with a prismatic or angular cylindrical shape, and includes, as outer surfaces, a joining surface configured to join to a to-be-joined surface, and an inclined surface inclined relative to the to-be-joined surface. The inclined surface is a mounting surface on which is mounted a reflective film that reflects light emitted from a light source. The joining surface includes a plurality of first grooves extending in a longitudinal direction of the structure and a plurality of second grooves intersecting the first grooves. The first grooves are open at both ends, and the second grooves are sealed at an end portion located on a side where light is reflected by the reflective film.

A position measuring mirror according to the present disclosure includes a reflective film mounted on the inclined surface of the mirror mounting member. An exposure apparatus according to the present disclosure includes a substrate stage to which the position measuring mirror is joined.

### Brief Description of Drawings

FIG. 1(a) is a schematic perspective view of a mirror mounting member according to an embodiment of the present disclosure, viewed from an inclined surface side, FIG. 1(b) is a schematic perspective view of the mirror mounting member viewed from a joining surface side, and FIG. 1(c) is a side view.
FIG. 2 is a front view illustrating a joining surface according to an embodiment of the present disclosure.
FIG. 3 is an enlarged view of an A part in FIG. 2.
FIG. 4 is a schematic view of an enlarged cross section of an inner peripheral surface surrounding a through hole of a structure illustrated in FIG. 1.
FIG. 5 is a schematic perspective view illustrating an example of a substrate stage.

### Description of Embodiments

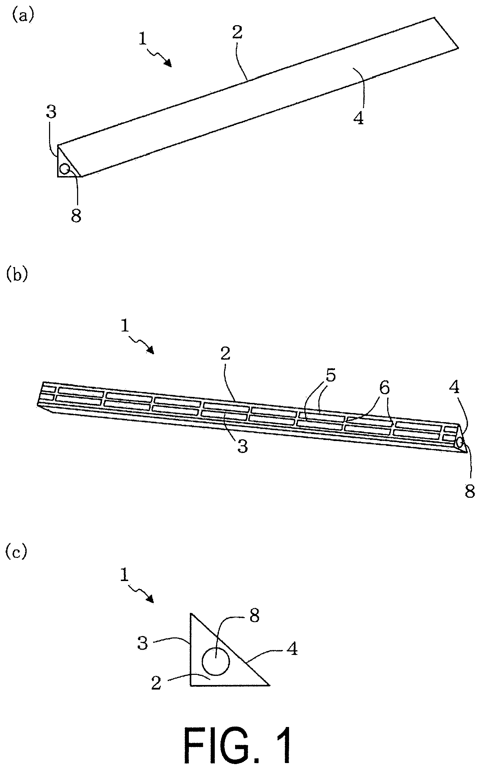

A mirror mounting member according to an embodiment of the present disclosure will be described below with reference to the drawings. FIGS. 1(a) to 1(c) illustrate a mirror mounting member 1 according to the present embodiment. As illustrated in (a) to (c) in the figure, the mirror mounting member 1 is formed of a structure 2 with an angular cylindrical shape, and includes, as outer surfaces, a joining surface 3 configured to join to a to-be-joined surface, and an inclined surface 4 inclined relative to the joining surface. The to-be-joined surface is, for example, a mirror 104 surface mounted on a side surface of a substrate stage 100 illustrated in FIG. 5.

The inclined surface 4 is inclined relative to the joining surface 3 at an angle that is, for example, 44.8° to 45.2°. The flatness of the inclined surface 4 is, for example, 316.4 nm or less.

The structure 2 has a through hole 8 along the longitudinal direction, and the through hole 8 has a circular cross-sectional shape orthogonal to the longitudinal direction. The diameter of the through hole 8 is, for example, 6 mm or more and 10 mm or less.

High dimensional stability, heat resistance, heat resistance deformation, and the like are required for the material of the structure 2. In view of this, a ceramic, a glass, or the like having an average coefficient of linear expansion within ±2 × 10⁻⁶/K from 40°C to 400°C can be used as the material.

Examples of such a ceramic include ceramics including, as a primary component, cordierite, lithium aluminosilicate, zirconium potassium phosphate, or mullite. A ceramic including, as the primary component, cordierite may contain 0.4 mass% or more and 0.6 mass% or less of Ca in terms of CaO, 2.3 mass% or more and 3.5 mass% or less of Al in terms of Al2O3, and 0.6 mass% or more and 0.7 mass% or less of Mn and Cr in terms of MnCr2O4. The ceramic may have an average coefficient of linear expansion within ±20 × 10⁻⁹/K.

The ceramic including, as the primary component, lithium aluminosilicate may contain 20 mass% or less of silicon carbide.

Examples of the glass include glass including, as a primary component, titanium silicate. With a member made of a ceramic or a glass having a small average coefficient of linear expansion, the structure has high reliability due to the small change in shape even when exposed to large temperature changes.

Here, when the structure 2 is made of a ceramic, the average coefficient of linear expansion may be determined in accordance with JIS R 1618: 2002.

When the structure 2 is made of a glass, the average coefficient of linear expansion may be determined in accordance with JIS R 3251: 1995.

Note that when the average coefficient of linear expansion of the structure 2 is within ±1 × 10⁻⁶/K, the measurement may be performed using an optical heterodyne method 1 optical path interferometer.

Here, the "primary component" of the ceramic refers to a component accounting for 60 mass% or more, of a total of 100 mass% of the components included in the ceramic of interest. In particular, the primary component may preferably be a component accounting for 95 mass% or more of a total of 100 mass% of the components included in the ceramic of interest. The components included in the ceramic may be determined using an X-ray diffraction apparatus (XRD). The content of each component may be determined by identifying the component, determining the content of the element constituting the component using a fluorescent X-ray analyzer (XRF) or an ICP emission spectrophotometer and converting it into the content of the identified component. Note that the same applies to glass.

The shape of the structure 2 is not particularly limited as long as the shape includes the joining surface 3 and the inclined surface 4. A shape other than the angular tube shape described above, that is, a prismatic shape, may be employed. In particular, as illustrated in FIG. 1(c), a substantially triangular cylinder or a substantially triangular prism is preferable.

The inclined surface 4 is a mounting surface for mounting a reflective film (not illustrated) for reflecting an optical axis of light emitted from a light source for position measurement. Examples of the reflective film include metal films made of aluminum, gold, silver, and the like.

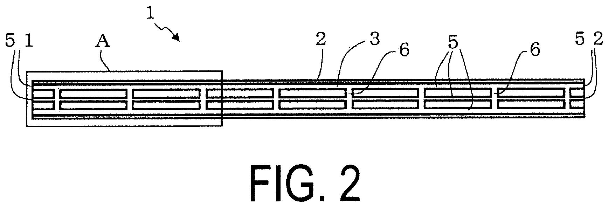

As illustrated in FIG. 1(b), the joining surface 3 includes a plurality of first grooves 5 extending in the longitudinal direction of the structure 2, and a plurality of second grooves 6 intersecting the first grooves 5. Specifically, as illustrated in FIG. 2, the second grooves 6 extend in a direction orthogonal to the first grooves 5, that is, in a transverse direction orthogonal to the longitudinal direction of the structure 2.

Note that in the present embodiment, three first grooves 5 are formed, but the configuration is not limited to this, and the number of first grooves 5 formed may be in a range from three to six. The number of second grooves 6 formed may be in a range from 6 to 12.

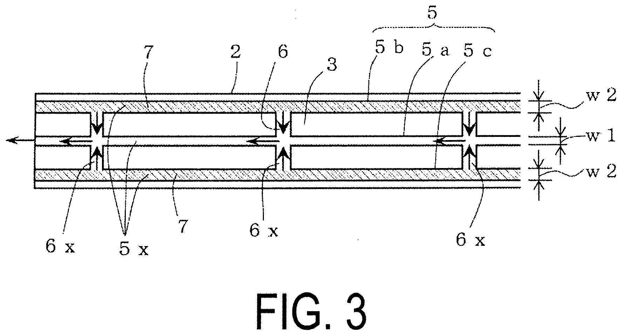

As illustrated in FIG. 2, the first grooves 5 have both ends 51 and 52 open. With this configuration, as indicated by arrows in FIG. 3, which is an enlarged view of an A part in FIG. 2, when first grooves 5b and 5c located on both sides of the joining surface 3 in the transverse direction serve as adhesive application portions 7 (the adhesive application portions are hatched for the sake of convenience) to be coated/filled with an adhesive, the openings serve as an air discharge path when applying adhesive to the first grooves 5b and 5c and at the time of bonding to the to-be-joined surface.

On the other hand, the second grooves 6 have both ends in contact with and in communication with the first grooves 5b and 5c located at both ends of the structure 2 in the transverse direction, to be sealed. Thus, outflow of the adhesive from the adhesive application portions 7 through the second grooves 6 is suppressed, whereby joining efficiency is improved. Note that while both ends of the second grooves 6 are sealed in FIG. 3, the end portion located on the side where the light is reflected by the reflective film (that is, the end portion 105 in the direction where the reference mirror is located, as illustrated in FIG. 5) need only be sealed.

As illustrated in FIG. 3, a width w1 of a first groove 5a located in a center portion of the structure 2 in the transverse direction is smaller than a width w2 of the other first grooves 5b and 5c located on both sides of the center portion. With this configuration, the rigidity of the structure 2 is less likely to be compromised than a case where the plurality of first grooves 5 all have the same width, whereby a change in the flatness of the mounting surface for mounting the reflective film can be suppressed. This is because while the other first grooves 5b and 5c located on both sides are the adhesive application portions 7 and thus require a sufficiently large width, the first groove 5a located in the center portion only needs to have a groove width sufficient for allowing air to escape at the time of application of adhesive to the first grooves 5b and 5c and at the time of joining, and thus does not need to have a large width, as described later. With the air discharge path thus provided, the outflow of the adhesive from the joining surface 3 can be suppressed. For example, the width w1 is 1.7 mm or more and 2.3 mm or less, and the width w2 is 2.7 mm or more and 3.3 mm or less.

The plurality of first grooves 5 are preferably disposed to be mirror symmetrical with respect to the center line in the longitudinal direction of the joining surface 3. This line is a line extending in the longitudinal direction at a position corresponding to half of the entire length of the joining surface 3 in the transverse direction, and is a center line of the first groove 5a in the embodiment illustrated in FIG. 3. The plurality of first grooves 5 are preferably disposed at equal intervals in the transverse direction of the structure 2. With this configuration, a partial change in the transverse direction of the joining surface 3 can be suppressed, whereby a change in the flatness of the mounting surface is suppressed. Here, disposing the first grooves 5 at equal intervals refers to a state in which the center lines of the respective first grooves 5 are at equal intervals.

The plurality of second grooves 6 are preferably disposed to be mirror symmetrical with respect to the center line in the transverse direction of the joining surface 3. This line is a line extending in the transverse direction at a position corresponding to half of the entire length of the joining surface 3 in the longitudinal direction. The plurality of second grooves 6 are preferably disposed at equal intervals in the longitudinal direction of the joining surface 3. With this configuration, a partial change in the longitudinal direction of the joining surface 3 can be suppressed, whereby a change in the flatness of the mounting surface is suppressed. Here, disposing the second grooves 6 at equal intervals refers to a state in which the center lines of the respective second grooves 6 are at equal intervals.

Of the plurality of first grooves 5 and the plurality of second grooves 6, at least the adhesive application portions 7 preferably have a groove width larger than a groove depth. As a result, the adhesive area increases while the rigidity of the structure 2 is maintained, and therefore, the adhesive strength with respect to a to-be-joined member such as the substrate stage can be increased.

A first bottom surface 5x of each of the first grooves 5 is preferably a blasted surface or a laser machined surface. Regardless of whether the first bottom surface 5x of the first groove 5 is a blasted surface or a laser machined surface, the arithmetic average roughness (Ra) is more likely to be larger than that of a ground surface. Therefore, a high anchoring effect can be obtained in a bonding process with respect to the to-be-joined member, and the reliability of the joining is maintained even if a vibration is applied.

Similarly, a second bottom surface 6x of each of the second grooves 6 is preferably a blasted surface or a laser machined surface.

The inclined surface 4, which is the mounting surface of the reflective film, preferably has an arithmetic average roughness Ra of 0.01 µm or more and 0.5 µm or less. When the arithmetic average roughness Ra is 0.01 µm or more, an appropriate anchoring effect can be obtained when the reflective film is formed by a vapor deposition method. When the arithmetic average roughness Ra is 0.5 µm or less, there are relatively fewer deep scratches on the inclined surface 4; therefore, coarse floating particles are less likely to adhere to the inside of the scratches. When the arithmetic average roughness Ra is within the range described above, the joining strength of the reflective film is improved, and the flatness of the surface of the reflective film is also reduced.

The arithmetic average roughness Ra of the inclined surface 4 is determined in accordance with JIS B0601: 2001. For example, a surface roughness measuring machine (Surf Coder) SE500, manufactured by Kosaka Laboratory Ltd., may be used, and the measurement conditions include a stylus radius of 5 µm, a measurement length of 2.5 mm, and a cutoff value of 0.8 mm.

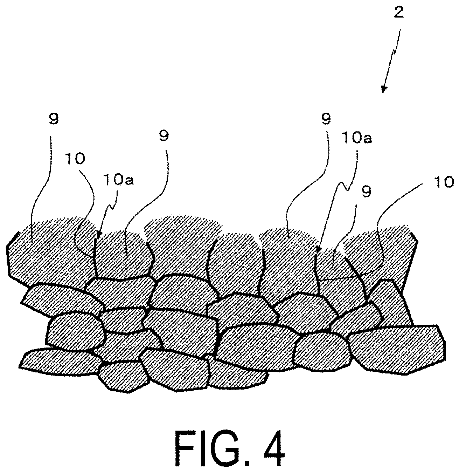

FIG. 4 is a schematic view of an enlarged cross section of an inner peripheral surface surrounding the through hole 8 of the structure 2 illustrated in FIGS. 1(a) to 1(c), and a diagram illustrating an example of a cross section cut along a plane including the center line of the through hole 8.

The inner peripheral surface surrounding the through hole 8 of the structure 2 may have crystal particles 9 protruding from an exposed portion 10a of a grain boundary phase 10 present between the crystal particles.

In such a configuration, the grain boundary phase 10 is located in a recessed state from the crystal particles 9. As a result, the contact angle with pure water, ultrapure water, or the like becomes smaller, and hydrophilicity (wettability) is further improved, whereby the cleaning efficiency is increased.

A position measuring mirror includes a foundation layer (not illustrated) between the inclined surface 4 and the reflective film. The foundation layer may be made of at least one of chromium, chromium oxide, yttrium oxide, lanthanum titanate, silicon oxide, titanium oxide, aluminum oxide, and magnesium aluminate.

The foundation layer made of these components increases adhesion between the inclined surface 4 and the reflective film, and corrosion caused by water vapor contained in pores opening on the inclined surface 4 and brought into contact with the reflective film can be suppressed.

The composition formulae of chromium oxide, yttrium oxide, lanthanum titanate, silicon oxide, titanium oxide, aluminum oxide, and magnesium aluminate are, for example, CrO, Cr₂O₃, Y₂O₃, LaTiO₃, La₂Ti₃O₈, SiO₂, TiO₂, Al₂O₃, and MgAl₂O₄.

The thickness of the foundation layer is, for example, preferably from 10 to 200 nm, and particularly preferably from 30 to 80 nm.

The position measuring mirror includes a highly reflective film (not illustrated) on the surface of the reflective film. The highly reflective film may be made of at least one of yttrium oxide, magnesium fluoride, lanthanum titanate, silicon oxide, titanium oxide, and aluminum oxide.

The highly reflective film can have a higher reflectivity due to the interference effect of light.

The highly reflective film made of these components can increase the reflectivity, and corrosion caused by water vapor contained in the air and brought into contact with the reflective film can be suppressed.

The composition formulae of yttrium oxide, magnesium fluoride, lanthanum titanate, silicon oxide, titanium oxide, and aluminum oxide are, for example, Y₂O₃, MgF, LaTiO₃, La₂Ti₃O₈, SiO₂, TiO₂, and Al₂O₃.

Additionally, the highly reflective film may include a plurality of laminates including a low refractive index layer and a high refractive index layer having a different thickness from the low refractive index layer.

With such a configuration, a high reflectivity can be obtained in a wide wavelength range.

In the laminates, for example, the low refractive index layer is made of SiO₂ or MgF, and the high refractive index layer is made of Nb₂O₅, TiO₂, or HfO₂. The difference in their thicknesses (physical layer thicknesses) is 1 nm or more and 50 nm or less. The number of laminates is 20 or more (the number of layers is 40 or more). The total thickness of the laminates is, for example, 400 nm or more and 3000 nm or less.

In the mirror mounting member 1 of the present disclosure, the joining surface 3 includes the plurality of first grooves 5 extending in the longitudinal direction of the structure 2 and the plurality of second grooves 6 intersecting the first grooves 5. The first grooves 5 are open at both ends, and the second grooves 6 are sealed at the end portion located on the side where the light is reflected by the reflective film. Thus, when an adhesive is used for mounting on the side surface of the substrate stage 100, the reflective film, the foundation layer, and the highly reflective film are less likely to be affected by the contraction of the adhesive, and the position of the substrate stage can be accurately measured.

The mirror mounting member 1 of the present disclosure can be used as a position measuring mirror in a state in which the reflective film is mounted on the inclined surface 4. In other words, similar to the inclined surface mirror 104 illustrated in FIG. 5, by the mirror mounting member 1 being joined to a side surface such as that of the substrate stage 100, the position of the substrate stage 100 can be measured. At this time, because the mirror mounting member 1 of the present disclosure reduces the flatness of the reflective film mounted on the inclined surface 4, the position of the substrate stage 100 or the like can be accurately measured.

Accordingly, the present disclosure can be suitably applied to an exposure apparatus including a substrate stage to which a position measuring mirror is joined. Furthermore, the position measuring mirror of the present disclosure can be applied not only to the exposure apparatus, but also to applications where accurate position measurement is required.

Next, an example of a method of manufacturing the mirror mounting member of the present disclosure will be described. A case in which the structure is made of a ceramic including, as a primary component, cordierite is described.

First, synthesized cordierite powder, which is produced by calcination and pulverization of a blended powder prepared by mixing the powders of magnesium carbonate, aluminum oxide, and silicon oxide at a predetermined ratio, and aluminum oxide powder, and calcium carbonate powder are weighed at a predetermined ratio to prepare a primary raw material.

Here, for example, the content of the aluminum oxide powder contained in a total of 100 mass% of the primary raw material may be 3 mass% or more, and the content of the calcium carbonate powder in terms of CaO may be 0.4 mass% or more and 0.6 mass% or less, and the content of the synthesized cordierite powder may be 95 mass% or more.

With such a ratio, the ceramic can have an absolute value of the average coefficient of linear expansion of 0.03 ppm/°C or less from 40°C to 400°C, a specific rigidity of 57 GPa·cm³/g or more, and a four-point bending strength of 250 MPa or more.

In order to improve the mechanical strength and the chemical resistance of the ceramic, a total of 100 mass% of the primary raw material may include 3 mass% or less of zirconium oxide powder.

Then, after the primary raw material is wet-blended, a binder is added to obtain a slurry. The slurry is then sprayed and dried by a spray granulation method (spray drying method) to obtain granules. The granules are filled in a mold and molded by a hydrostatic pressure press-molding (rubber press) method or a powder press-molding method to obtain a press-molded body having a prismatic shape. If necessary, after the through hole is formed by machining, a structure having a prismatic or angular cylindrical shape can be obtained by firing at a maximum temperature of higher than 1400°C and 1450°C or lower in the atmosphere.

Furthermore, after the firing, the pressure can be set to 100 to 200 MPa and the temperature can be set to 1000 to 1350°C for hot isostatic pressing to further densify the structure.

Then, a mask may be applied to the portion of the fired surface that is to become the joining surface after polishing and that is not machined, and the grooves are formed by blasting or laser machining in this state.

After forming the grooves, the mask is removed, and at least a first fired surface that becomes the inclined surface after polishing and a second fired surface that becomes the joining surface are polished to obtain the mirror mounting member of the present disclosure.

Regarding the details of polishing, for example, first, polishing is performed on a polyurethane pad for 2 to 10 hours using abrasive particles of aluminum oxide having an average particle size of 1 µm. Next, the inclined surface and the joining surface can be obtained by polishing on the polyurethane pad for about 2 to 10 hours using cerium oxide abrasive particles having an average particle size of 1 µm.

For the purpose of reducing residual stress generated by firing or the like, at least one of a third fired surface connecting the first fired surface and the second fired surface and the end surfaces located at both ends in the longitudinal direction of the structure may be polished.

Furthermore, the position measuring mirror including the foundation layer, the reflective film, the highly reflective film, and the like can be formed by, for example, vacuum deposition, vapor deposition such as ion assisted deposition, sputtering, or ion plating.

### Reference Signs List

1 Mirror mounting member
2 Structure
3 Joining surface
4 Inclined surface
5, 5a, 5b, 5c First groove
5x First bottom surface
6 Second groove
6x Second bottom surface
7 Adhesive application portion
8 Through hole
9 Crystal particle
10 Grain boundary phase
10a Exposed portion
100 Substrate stage
101 Substrate
102 Surrounding member
103 Inclined surface mirror
104 Mirror
105 End portion

## Claims

1. A mirror mounting member formed of a structure with a prismatic or angular cylindrical shape, the mirror mounting member comprising:
as outer surfaces,
a joining surface configured to join to a to-be-joined surface; and
an inclined surface inclined relative to the joining surface, wherein
the inclined surface is a mounting surface on which is mounted a reflective film that reflects light emitted from a light source,
the joining surface comprises a plurality of first grooves extending in a longitudinal direction of the structure and a plurality of second grooves intersecting the first grooves, and
the first grooves are open at both ends, and the second grooves are sealed at least at an end portion located on a side where light is reflected by the reflective film.

2. The mirror mounting member according to claim 1, wherein
the structure is made of a ceramic or a glass having an average coefficient of linear expansion within ±2 × 10⁻⁶/K from 40°C to 400°C.

3. The mirror mounting member according to claim 1 or 2, wherein
both ends of the second grooves are sealed.

4. The mirror mounting member according to any one of claims 1 to 3, wherein
on the joining surface, a width of the first groove located in a center portion of the structure in a transverse direction intersecting the longitudinal direction is smaller than a width of the other first grooves located on both sides of the center portion.

5. The mirror mounting member according to any one of claims 1 to 4, wherein
the plurality of first grooves are disposed to be mirror symmetrical with respect to a center line in a longitudinal direction of the joining surface.

6. The mirror mounting member according to any one of claims 1 to 5, wherein
the plurality of first grooves are disposed at equal intervals in a transverse direction of the joining surface.

7. The mirror mounting member according to any one of claims 1 to 6, wherein
the plurality of second grooves are disposed to be mirror symmetrical with respect to a center line in a transverse direction of the joining surface.

8. The mirror mounting member according to any one of claims 1 to 7, wherein
the plurality of second grooves are disposed at equal intervals in a longitudinal direction of the joining surface.

9. The mirror mounting member according to any one of claims 1 to 8, wherein
of the plurality of first grooves and the plurality of second grooves, at least an adhesive application portion has a groove width larger than a groove depth.

10. The mirror mounting member according to any one of claims 1 to 9, wherein
a first bottom surface of each of the plurality of first grooves is a blasted surface or a laser machined surface.

11. The mirror mounting member according to any one of claims 1 to 10, wherein
a second bottom surface of each of the plurality of second grooves is a blasted surface or a laser machined surface.

12. The mirror mounting member according to any one of claims 1 to 11, wherein
the inclined surface has an arithmetic average roughness Ra of 0.01 µm or more and 0.5 µm or less.

13. The mirror mounting member according to any one of claims 1 to 12, wherein
the structure comprises a through hole along the longitudinal direction, and an inner peripheral surface surrounding the through hole comprises crystal particles protruding from an exposed portion of a grain boundary phase present between the crystal particles.

14. A position measuring mirror comprising:
a reflective film mounted on the inclined surface of the mirror mounting member described in any one of claims 1 to 13.

15. The position measuring mirror according to claim 14, further comprising:
a foundation layer between the inclined surface and the reflective film, wherein
the foundation layer is made of at least one selected from chromium, chromium oxide, yttrium oxide, lanthanum titanate, silicon oxide, titanium oxide, aluminum oxide, and magnesium aluminate.

16. The position measuring mirror according to claim 15, further comprising:
a highly reflective film on a surface of the reflective film, wherein
the highly reflective film is made of at least one selected from yttrium oxide, magnesium fluoride, lanthanum titanate, silicon oxide, titanium oxide, and aluminum oxide.

17. The position measuring mirror according to claim 15, further comprising:
a highly reflective film on a surface of the reflective film, wherein
the highly reflective film comprises a plurality of laminates comprising a low refractive index layer, and a high refractive index layer having a different thickness from the low refractive index layer.

18. An exposure apparatus comprising:
a substrate stage to which the position measuring mirror described in any one of claims 14 to 17 is joined.
